# EUROPEAN PATENT SPECIFICATION

(11) **EP 1 430 408 B1**
(45) Date of publication and mention of the grant of the patent: **11.04.2007**
(21) Application number: 02765186.8
(22) Date of filing: 03.09.2002
(51) Int. Cl.: G06F 13/42

(54) **ELECTRIC DEVICE WITH DATA COMMUNICATION BUS**
ELEKTRISCHES GERÄT MIT DATENKOMMUNIKATIONSBUS
DISPOSITIF ELECTRIQUE AVEC BUS DE COMMUNICATION DE DONNEES

(30) Priority: 11.09.2001 EP 01203427
(43) Date of publication of application: 23.06.2004
(73) Proprietor: Koninklijke Philips Electronics N.V., 5621 BA Eindhoven (NL)
(72) Inventor: NIEUWLAND, Andre, K., NL-5656 AA Eindhoven (NL); KLEIHORST, Richard, P., NL-5656 AA Eindhoven (NL); VAN DIJK, Victor, E., S., NL-5656 AA Eindhoven (NL); SALTERS, Roel, H., W., NL-5656 AA Eindhoven (NL)
(74) Representative: White, Andrew Gordon
(86) International application number: PCT/IB2002/003633
(87) International publication number: WO 2003/023628

(56) References cited:
- US-A- 5 717 343
- US-A- 6 137 849
- PATENT ABSTRACTS OF JAPAN vol. 1998, no. 09, 31 July 1998 (1998-07-31) & JP 10 111743 A (NEC CORP), 28 April 1998 (1998-04-28)

## Description

The invention relates to an electronic device, comprising:
a data communication bus having a plurality of substantially parallel conductors, the plurality of substantially parallel conductors comprising a first conductor and a second conductor; and
a control circuit for providing the first conductor with a first electrical signal and the second conductor with a second electrical signal.

In the art of integrated circuit (IC) design, data communication buses, e.g. communication devices for connecting at least one sender to at least one receiver, are well-known devices for establishing high-speed communication between various components e.g. processors, cores, memories, peripherals and so on. With the ongoing downscaling of the dimensions of semiconductor devices, the distances between the conductors of the data communication buses become smaller, which introduces various interference problems. This can be explained in terms of a mutual capacitance (Cm) of neighboring conductors, which becomes larger with the aforementioned decrease in technology dimensions. It is expected that Cm will become so large that it will dominate the transient behavior of the conductors. Two major unwanted effects arise from this. First of all, additional noise, e.g. crosstalk, is introduced with increasing Cm, leading to a deterioration of signal integrity and increase of communication latencies because more time is required to charge Cm. Moreover, power consumption increases as a result of the larger Cm. For instance, for a 0→1 transition next to a 1→0 transition on two adjacent conductors the polarity of the voltage on the capacitor is reversed; first the capacitor has to be discharged before it can be charged again which increases both power consumption and signal propagation delay when Cm becomes larger. Since the power consumption increases with the downscaling of semiconductor device dimensions, the increase in power consumption associated with an increasing Cm is a highly unwanted effect, because these power issues are increasingly becoming a limiting factor to integration density.

In the proceedings of the DATE conference 2000 , "A Bus Delay Reduction Technique Considering Crosstalk" on p. 446 by K. Hiroshe and H. Yasuura, a data communication bus with inverter chains of different lengths coupled to the various conductors has been disclosed. This results in a reduction of crosstalk associated with opposite transitions, because the temporal overlap between the rising and falling edge of the respective transistions is reduced. In other words, a (01) → (10) transition, with the bracketed values representing the signal values on two neighboring conductors, proceeds via a (11) or (00) intermediate state, depending on which transition exhibits the longer delay.

It is a disadvantage of the aforementioned arrangement that the symmetrical e.g. (00)→(11) and (11)→(00) transitions are also selectively delayed. In both the (00) and (11) states, the mutual capacitor Cm is uncharged, and as long as the (00)→(11) and (11)→(00) transitions take place simultaneously no charging of Cm is required. If, however, a delay is introduced in one of the transitions with respect to the other, the (00) →(11) transition proceeds via a (01) or (10) state with associated charging and discharging of Cm. Although the aforementioned arrangement improves overall signal integrity, it is a disadvantage that the power consumption of the bus communication is increased for certain transitions.

Inter alia, it is an object of the present invention to provide a data communication bus of the kind described in the opening paragraph for which the overall power consumption associated with signal transitions on the conductors of a data communication bus is reduced.

Now, this object is realized by first signal transition dependent delay circuit for delaying a first electrical signal transition; and second signal transition dependent delay circuit for delaying a second electrical signal transition.
The delay of a 0→1 or a 1→0 transition causes the (01)→(10) and (10) →(01) transitions to take place through an intermediate (11) or (00) state, thus yielding a reduction in power consumption, because a full reversal of the capacitor polarity associated with the direct (01) →(10) and (10) → (01) transitions is avoided by the intermediate (11) or (00) states, in which the capacitor is uncharged. Preferably, the first and second delay circuits introduce a substantially equal delay. As a consequence, each of the (00) → (11) and (11) → (00) transitions is then delayed by substantially the same amount of time, which prevents the occurrence of the unwanted intermediate (10) and (01) states during symmetrical transitions, thus avoiding the unneccesary charging of Cm. Consequently, a significant power reduction is achieved.

It is an advantage if the first signal transition dependent delay circuit comprises a logic element having a first input being coupled to an input of the delay circuit via a first input delay element; a second input being coupled to the input of the delay circuit; and an output being coupled to the first conductor.
Logic elements are very suitable elements for introducing a transition dependent delay, because only specific transitions cause a change in the output value of a logic element. In addition, the transition characteristics of standard logic elements usually are designed to be highly symmetrical, i.e. the rising edges and falling edges of the respective 0→ 1 and 1→0 transitions are very similarly shaped, which is advantageous in terms of signal integrity.

It is an advantage if the logic element comprises an AND gate, and the first input delay element comprises an inverter chain having an even number of inverters. Driving a signal through both inputs of an AND gate, whereby one of the inputs is delayed with respect to the other input, the 0 →1 transition on a conductor is delayed, whereas the 1 → 0 transition is not, because for the 0 → 1 transition both inputs of the AND gate have to reach the '1' state as opposed to the 1 → 0 transition, where the less delayed input reaching a'0' state wil already cause the AND gate to output a logic 0.

It is another advantage if the logic element comprises a NOR gate; the first input delay element comprises an inverter chain having an even number of inverters and the first input and second input of the logic element being coupled to the input of the first transition dependent delay circuit via an inverter.
Driving a signal through both inputs of a NOR gate, whereby one of the inputs is delayed with respect to the other input path, the 0 → 1 transition on a conductor is delayed, whereas the 1 →0 transition is not, because for the 0 → 1 transition both inputs of the NOR gate have to reach the '0' state as opposed to the 1 → 0 transition, where the less delayed input reaching a'1' state wil already cause the NOR gate to output a logic 0.

It is noted that in US patent 4,905,192 a semiconductor memory is disclosed. In this patent, the aforementioned delay elements, e.g. the NOR and AND gate, can be found in Fig.7 and 8 respectively. However, in this patent the transition dependent delay circuits are exclusively being used in memory devices to generate a word line driver signal only after a decoder inhibit signal is generated, in order to provide high speed access to a memory when the redundancy circuit is not used, as stipulated in col. 1 lines 16-63, col. 2 lines 14-15 and col. 5 lines 6-16. As clearly stated in col. 1 lines 56-63, the motivation for using transition dependent delay circuit is to set optimum timings in both cases where the redundancy circuit is used and not used. It is emphasized that the aforementioned prior art is silent about the effect of introducing transition dependent delays to reduce power consumption in high-speed communication devices e.g. data communication buses. In addition, the use of transition dependent delays in bus communications introduces asymmetry in the timing of the rising and falling edges of the signal on the bus conductors, which is a contra-intuitive concept in a technical field where signal symmetry is considered to be an advantageous characteristic. Consequently, it is stipulated that the use of transition dependent delay circuit to reduce power consumption is a novel and non-obvious application of the transition dependent delay circuit.

It is a further advantage if the first signal transition dependent delay circuit comprises an asymmetric inverter having an input coupled to the control circuit; an output coupled to the first conductor; a first transistor having a first resistance; and a second transistor having a second resistance. The use of an inverter having transistors with different resistances also introduces transition dependent delays. In conventional inverters, the width over length (W/L) ratio of the transistors is chosen such that both transistors exhibit comparable resistances to ensure symmetrical rising and falling edges in the switching behavior. As a result of the adjustment of the W/L ratio of at least one of the transistors, the transistor with the smaller ratio will take longer to become conductive due to its increased resistance and as a result the transition of the signal associated with the conductivity of that transistor will become delayed.

For the previous embodiment, it is another advantage if the output of the asymmetric inverter is coupled to the first conductor via a capacitor and a buffer circuit. To compensate for the introduced asymmetries between the shape of the rising and falling edges of the signal, the asymmetric inverter is coupled to a capacitor and a buffer circuit, which will create similar edge shapes once the respective transistors become conductive.

The invention is described in more detail and by way of non-limiting examples with reference to the accompanying drawings, wherein:
Fig.1 shows the electronic device according to the present invention,
Fig. 2 shows a schematic layout of a number of data bus conductors and accompanying capacitances,
Fig.3 shows a transition dependent delay circuit of the electronic device according to an embodiment of the present invention,
Fig.4 shows a transition dependent delay circuit of the electronic device according to another embodiment of the present invention, and
Fig. 5 shows a transition dependent delay circuit of the electronic device according to yet another embodiment of the present invention.

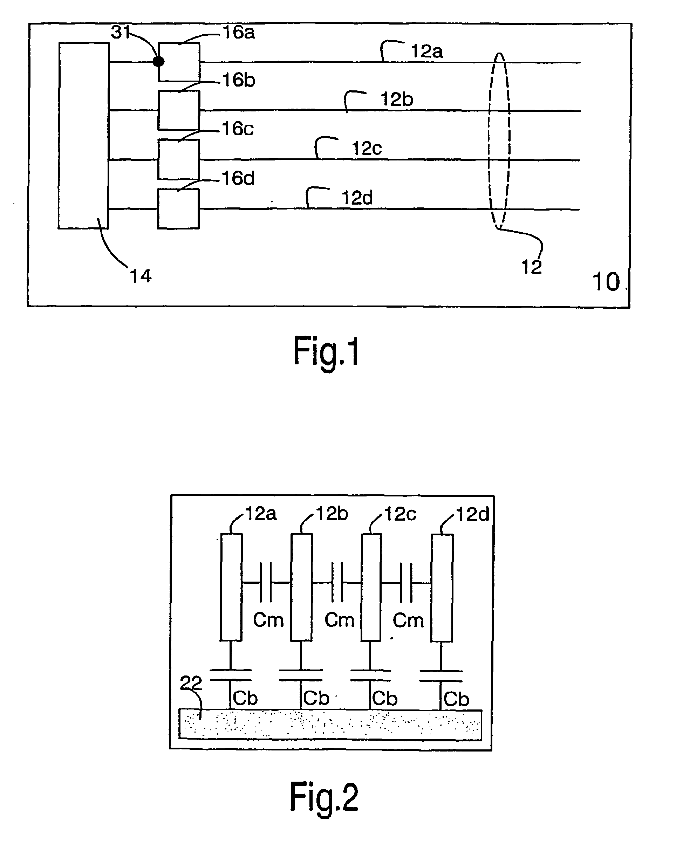

In Fig. 1, an electronic device 10 has a data communication bus 12. The electronic device 10 can be a microprocessor, an integrated circuit, a multiple chip module or any other semiconductor device utilizing a data communication bus 12 to enable communication between the various components of the electronic device 10, e.g. memory, CPU, data storage means, peripheral devices and so on. Data communication bus 12 embodies a plurality of substantially parallel conductors 12a, 12b, 12c, 12d with a first conductor 12a and a second conductor 12b, the exact number of conductors being governed by the required bandwidth of the data communication having to take place on the bus 12. Control circuit 14 drives an electrical signal onto the conductors 12a-d. Now, according to the invention, this arrangement is extended with a first transition dependent delay circuit 16a coupling control circuit 14 to first conductor 12a and second transition dependent delay circuit 16b coupling control circuit 14 to second conductor 12b. For reasons of clarity, an input 31 of delay circuit 16a is explicitly shown. It is emphasized that the inclusion of input 31 does not necessarily suggest the requirement of additional hardware for first delay circuit 16a, nor does it suggest a necessary difference between first delay circuit 16a and the other delay circuits 16b-d. Preferably, this arrangement is extended to all conductors 12a-d present in data communication bus 12; i.e. transition dependent delay circuits 16c and 16d are coupled between control circuit 14 and conductors 12c and 12d respectively. In addition, it is preferable that delay circuits 16a-d introduce substantially equal delays for reasons that will be discussed in more detail later.

It is emphasized that this arrangement is shown as a mere example; it will be obvious to anyone skilled in the art that this arrangement can easily be extended and/or altered without departing from the scope of the invention. In addition, although transition dependent delay circuits 16a-d are shown outside control circuit 14, it will be obvious to those skilled in the art that delay circuits 16a-d can alternatively be integrated in control circuit 14.

The following Figs will be described with backreference to the detailed description of Fig.1, and reference numerals introduced in Fig.1 will have the same meaning unless stated otherwise.

The power reduction associated with the presence of transition dependent delay circuits 16a-d will be explained in more detail with the aid of Fig.2. In CMOS technology, the behavior of conductors 12a-d is dominated by two capacitances: the mutual capacitance Cm between two neighboring conductors e.g. conductor 12a and conductor 12b and so on, and the base capacitance Cb, which is the capacitance between conductor 12a and the substrate 22. Obviously, the latter also holds for conductors 12b-d. With the downscaling of CMOS technology, the distance between neighboring conductors 12a-d in a data communication bus 12 decreases, which increases Cm. Cb is less sensitive to the downscaling, and, consequently, Cm will dominate the switching behavior of data communication bus 12 with the ongoing downscaling into the deep submicron domain. This has a detrimental effect on the power consumption of data communication bus 12, as will be demonstrated below. As a simple example, in Table I the charge that has to be stored in Cm by power supply (ΔQₛᵤₚₚ) associated with an undelayed and delayed simultaneous signal transition on two neighboring wires is given.

**Table I**

| | transition | additional | Cm polarity | ΔQₛᵤₚₚ |
|---|---|---|---|---|
| | (12a 12b) | delay* | | |
| (a) | (00) → (11) | none | 0 → 0 | |
| (b) | (00) → (01) → (11) | 0→1 (12a) | 0 → (-/+) → 0 | ~ Cₘ.V |
| (c) | (10) → (01) | none | (+/-)→ (-/+) | ~ Cₘ.2V |
| (d) | (10) → (11) → (01) | 1→0 (12a) | (+/-) → 0 → (-/+) | ~ Cₘ.V |

| | | | | |
|---|---|---|---|---|
| * on one of the two conductors | | | | |

In entry (a), the effect of an undelayed, or equally delayed, (00) → (11) signal transition on neigbouring conductors 12a and 12b is given. In the initial (00) state capacitor Cm is uncharged and because no voltage difference occurs between conductors 12a and 12b during the transition, capacitor Cm remains uncharged all through the transition; hence the charge transferred from power supply to Cm remains zero.

In entry (b), the effects of a delay on the (00)→ (11) signal transition of one of the neighboring conductors 12a and 12b are given. Here, the 0→1 transition on conductor 12a is delayed, leading to an intermediate voltage difference between conductor 12a and conductor 12b at intermediate state (01). In the intermediate state, capacitor Cm becomes charged with a polarity (-/+), in which the left sign denoted the polarity of the capacitor plate on the side of conductor 12a and the right sign denotes the polarity of the plate on the side of conductor 12b. Consequently, capacitor Cm with capacitance Cₘ will approximately be charged corresponding to Cₘ.V, with V being the voltage difference.

In entry (c), the effects of an undelayed, or mutually delayed, (10) → (01) signal transition on neigbouring conductors 12a and 12b are given. Here, the polarity of the plates of capacitor Cm both has to be reversed from initial state (+/-) to final state (-/+). This is associated with a charge of approximately Cₘ.2V having to be provided by the power supply. It is emphasized that this particular transition induces the largest charge flux from power supply to Cm, and is therefore associated with the highest peak current.

In entry (d), the effects of an delayed (10) → (01) signal transition on neigbouring conductors 12a and 12b are given. Here, the 1→0 transition on conductor 12a is delayed leading to an intermediate state (11) in the switching process. During this intermediate state, Cm is short-circuited via the power supply and the charge stored on Cm is equalized. Consequently, now Cm only has to be charged from a 0→(-/+) state, which is associated with a charge of approximately Cₘ.V having to be supplied by the power supply.

The charging behavior of Cm for the various simultaneous signal transitions on neighboring conductor 12a and 12b clearly shows that for symmetric e.g. (00) → (11) transitions, both transitions should be equally delayed as shown in entry (a) to avoid the occurrence of the intermediate (01) state shown in entry (b) with an associated non-zero charge flow from the power supply to mutual capacitor Cm. On the other hand, for antisymmetric e.g. (01) → (10) transitions, one of the transitions has to be delayed to introduce the intermediate (11) or (00) state shown in entry (d), thus reducing the charge flow from power supply to mutual capacitor Cm from Cₘ.2V associated with the transition in entry (c) to Cₘ.V. This makes the electronic device 10 of the present invention particularly advantageous, because it combines the transition behavior of advantageous entry (a) and advantageous entry (d); the symmetric transitions on conductors 12a and 12b are either undelayed or mutually delayed by the respective signal transition dependent delay circuits 16a and 16b, whereas one of the antisymmetric transitions on conductors 12a and 12b is selectively delayed by one of the transition dependent delay circuits 16a and 16b and, consequently, the peak currents associated with the antisymmetric signal transitions are reduced.

It is emphasized that it will be obvious to anyone skilled in the art that a significant power reduction is also achieved when more than two conductors are involved, and that the mirror images of the transitions shown in Table I yield the same behavior in terms of power consumption.

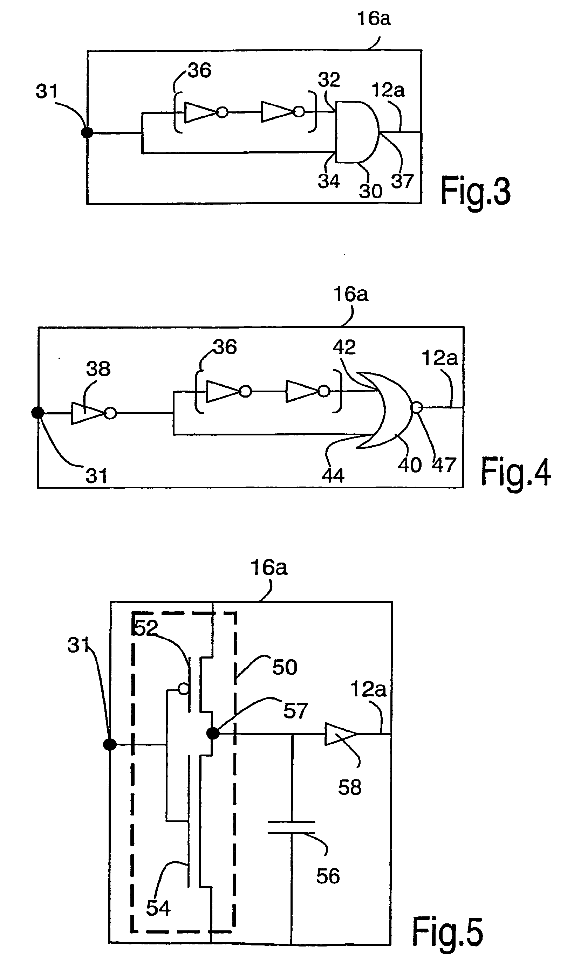

In Fig. 3, an embodiment of a transition dependent delay circuit 16a that combines the switching behavior of entries (a) and (d) of Table I is given. Obviously, the same embodiment can also be applied to delay circuits 16b-d. A 2-input AND gate 30 with first input 32 and second input 34 is given. The output 37 of AND gate 30 is connected to conductor 12a. The inputs 32 and 34 of AND gate 30 are coupled to control circuit 14 via input 31. Now, the transition dependent delay is introduced by inverter chain 36 or another delay element known from the art. Inverter chain 36 is inserted into the path of first input 32. This has the following effect. For a 1→0 transition, the logic '0' will be immediately propagated along second input 34, and AND gate 30 will immediately switch to a logic '0'. Therefore, the 1→0 transition is not delayed by this delay circuit 16a. However, a 0→1 transition will be delayed, because the 0→1 transition along first input 32 will be delayed by inverter chain 36. It is emphasized that in this arrangement inverter chain 36 needs to embody an even number of inverters to ensure the correct logic value reaching AND gate 30. AND gate 30 changes the signal value on its output 37 from a logic '0' to a logic '1' not earlier than that the logic '1' has rippled through the inverter chain 36, which effectively delays the 0→1 transition at conductor 12a. It is emphasized that, although no delay element is shown in the path of second input 34, it does not exclude its presence; the arrangement shown in Fig. 3 merely serves as an example.

In Fig. 4, another embodiment of transition dependent delay circuit 16a is shown. NOR gate 40 with a first input 42 and a second input 44 and an output 47 coupled to conductor 12a is shown. Again, the same arrangement can also apply to delay circuits 16b-d. Inverter chain 36 is arranged to delay the propagation of the signal coming from control circuit 14 via input 31 along the path of first input 42. In addition, inverter 38 inverts the logic value of the signal coming from control circuit 14 before providing it to first input 42 and second input 44. Again, a 1→0 transition will not be delayed by inverter chain 36, because as soon as as the logic '0' inverted by inverter 38 into a logic '1' reaches NOR gate 40 through second input 44, NOR gate 40 will output a logic '0' on its output 47 coupled to conductor 12a. For a 0→1 transition, however, the delay introduced by inverter chain 36 dominates the switching behavior; the logic '0' generated by inverter 38 has to reach NOR gate on both first input 42 and second input 44 before NOR gate 40 switches to a logic '1'. Again, the inverter chain has to embody an even number of inverters to ensure the output of a correct logical value to NOR gate 40.

It is emphasized AND gate 30 and NOR gate 40 can also be used to delay the 1→0 transition by applying well-known boolean logic redesign techniques. For example, an inverter not shown can be coupled between the output of AND gate 30 and conductor 12a in combination with an inverter not shown coupled to first input 32 and second input 34 similar to the arrangement with inverter 38 shown in Fig. 4. It will be obvious to anyone skilled in the art that many variations to delay circuits 16a-d are possible without departing from the scope of the invention.

The embodiment of delay circuit 16a shown in Fig. 5 does not incorporate a logic gate to introduce the transition dependent delay. Here, an asymmetric inverter 50 comprising a first transistor 52 and a second transistor 54 is used to introduce a transition dependent delay. The introduction of different dimensions e.g. different W/L ratios for the two transistors invokes asymmetric on/off switching of asymmetric inverter 50. Here, a relatively small pMOS transistor 52 causes a relatively slow 0→1 transition at the output 57 of asymmetric inverter 50 when the input value provided by control circuit 14 via input 31 becomes low. The relatively slow transition is caused by a relatively high resistance of pMOS transistor 52. On the other hand, a relatively large nMOS transistor 54 causes a relatively fast 1 →0 transition at the output 57 of asymmetric inverter 50 when the input value provided by control circuit 14 becomes high. The relatively fast transition is caused by a relatively low resistance of nMOS transistor 54. Obviously, this behavior can be reversed by interchanging the dimensions of first transistor 52 and second transistor 54. To ensure that the rising and falling edges of the signal outputted to conductor 12a via output 57 are of similar shape, delay circuit 16a is extended with a capacitor 56 and a buffer circuit 58. Buffer circuit 58 preferably comprises an inverter, not shown, to match the logic value outputted to conductor 12a to the logic value inputted from control circuit 14. In this case, the 0 → 1 transition outputted to conductor 12a is delayed in comparison to the 1→0 transition. It is stipulated that other delay circuits e.g. Schmitt trigger gates and comparable circuits can also be used without departing from the scope of the invention.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. In the device claim enumerating several means, several of these means can be embodied by one and the same item of hardware. The mere fact that certain measures are recited in mutually different dependent claims does not indicate that a combination of these measures cannot be used to advantage.

## Claims

1. An electronic device (10), comprising:
a data communication bus (12) having a plurality of substantially parallel conductors (12a, 12b, 12c, 12d), the plurality of substantially parallel conductors (12a, 12b, 12c, 12d) comprising a first conductor (12a) and a second conductor (12b); and
a control circuit (14) for providing the first conductor (12a) with a first electrical signal and the second conductor (12b) with a second electrical signal;
**characterized by** further comprising:
a first signal transition dependent delay circuit (16a) coupled to the first conductor (12a) for delaying a first electrical signal transition; and
a second signal transition dependent delay circuit (16b) coupled to the second conductor (12b) for delaying a second electrical signal transition.

2. An electronic device (10) as claimed in claim 1, **characterized in that** the first signal transition dependent delay circuit (16a) comprises a logic element (30; 40) having:
a first input (32; 42) being coupled to an input (31) of the first signal transition dependent delay circuit (16a) via a first input delay element (36);
a second input (34; 44) being coupled to the input (31) of the first signal transition dependent delay circuit (16a); and
an output (37; 47) being coupled to the first conductor (12a).

3. An electronic device (10) as claimed in claim 2, **characterized in that**:
the logic element (30; 40) comprises an AND gate (30); and
the first input delay element (36) comprises an inverter chain having an even number of inverters.

4. An electronic device (10) as claimed in claim 2, **characterized by**:
the logic element (30; 40) comprising a NOR gate (40);
the first input delay element (36) comprising an inverter chain having an even number of inverters; the first input (42) and the second input (44) of the logic element (40) being coupled to the input (31) of the first signal transition dependent delay circuit (16a) via an inverter (38).

5. An electronic device (10) as claimed in claim 1, **characterized in that** the first signal transition dependent delay circuit (16a) comprises an asymmetric inverter (50) having:
an input (31) coupled to the control circuit (14);
an output (57) coupled to the first conductor (12a);
a first transistor (52) having a first resistance; and
a second transistor (54) having a second resistance.

6. An electronic device (10) as claimed in claim 5, **characterized by** the output (57) of the asymmetric inverter (50) being coupled to the first conductor (12a) via a capacitor (56) and a buffer circuit (58).

7. An electronic device (10) as claimed in claim 1, **characterized in that** the first signal transition dependent delay circuit (16a) and the second signal transition dependent delay circuit (16b) are integrated in the control circuit (14).

## Patentansprüche

1. Elektronische Vorrichtung (10), mit:
einem Datenkommunikationsbus (12) mit einer Vielzahl von im Wesentlichen parallelen Leitern (12a, 12b, 12c, 12d), wobei die Vielzahl der im Wesentlichen parallelen Leiter (12a, 12b, 12c, 12d) einen ersten Leiter (12a) und einen zweiten Leiter (12b) aufweist, und
einer Steuerschaltung (14) zum Bereitstellen eines ersten elektrischen Signals für den ersten Leiter (12a) und eines zweiten elektrischen Signals für den zweiten Leiter (12b),
**gekennzeichnet durch**:
eine erste von einem Signalübergang abhängige Verzögerungsschaltung (16a), welche mit dem ersten Leiter (12a) zum Verzögern eines Übergangs eines ersten elektrischen Signals gekoppelt ist, und
eine zweite von einem Signalübergang abhängige Verzögerungsschaltung (16b), welche mit dem zweiten Leiter (12b) zum Verzögern eines Übergangs eines zweiten elektrischen Signals gekoppelt ist.

2. Elektronische Vorrichtung (10) nach Anspruch 1, **dadurch gekennzeichnet, dass** die erste von einem Signalübergang abhängige Verzögerungsschaltung (16a) ein Logikelement (30; 40) mit
einem ersten Eingang (32; 42), welcher mit einem Eingang (31) der ersten von einem Signalübergang abhängigen Verzögerungsschaltung (16a) über ein erstes Eingangsverzögerungselement (36) gekoppelt ist,
einem zweiten Eingang (34; 44), welcher mit dem Eingang (31) der ersten von einem Signalübergang abhängigen Verzögerungsschaltung (16a) gekoppelt ist, und
einem Ausgang (37; 47), welcher mit dem ersten Leiter (12a) gekoppelt ist, aufweist.

3. Elektronische Vorrichtung (10) nach Anspruch 2, **dadurch gekennzeichnet, dass**
das Logikelement (30; 40) ein UND-Gatter (30) aufweist, und
das erste Eingangsverzögerungselement (36) eine Invertiererkette mit einer geraden Anzahl von Invertierern aufweist.

4. Elektronische Vorrichtung (10) nach Anspruch 2, **dadurch gekennzeichnet, dass**
das Logikelement (30; 40) ein NOR-Gatter (40) aufweist, und
das erste Eingangsverzögerungselement (36) eine Invertiererkette mit einer geraden Anzahl von Invertierern aufweist, wobei der erste Eingang (42) und der zweite Eingang (44) des Logikelements (40) mit dem Eingang (31) der ersten von dem Signalübergang abhängigen Verzögerungsschaltung (16a) über einen Invertierer (38) gekoppelt sind.

5. Elektronische Vorrichtung (10) nach Anspruch 1, **dadurch gekennzeichnet, dass** die erste von dem Signalübergang abhängige Verzögerungsschaltung (16a) einen asymmetrischen Invertierer (50) mit:
einem mit der Steuerschaltung (14) gekoppelten Eingang (31),
einem mit dem ersten Leiter (12a) gekoppelten Ausgang (57),
einem ersten Transistor (52) mit einem hohen Widerstand, und
einem zweiten Transistor (54) mit einem zweiten Widerstand aufweist.

6. Elektronische Vorrichtung (10) nach Anspruch 5, **dadurch gekennzeichnet, dass** der Ausgang (57) des asymmetrischen Invertierers (50) mit dem ersten Leiter (12a) über einen Kondensator (56) und einer Pufferschaltung (58) gekoppelt ist.

7. Elektronische Vorrichtung (10) nach Anspruch 1, **dadurch gekennzeichnet, dass** die erste von dem Signalübergang abhängige Verzögerungsschaltung (16a) und die zweite von dem Signalübergang abhängige Verzögerungsschaltung (16b) in der Steuerschaltung (14) integriert sind.

## Revendications

1. Dispositif électronique (10), comprenant :
- un bus de communication de données (12) ayant une pluralité de conducteurs essentiellement parallèles (12a, 12b, 12c, 12d), la pluralité de conducteurs essentiellement parallèles (12a, 12b, 12c, 12d) comprenant un premier conducteur (12a) et un deuxième conducteur (12b) ; et
- un circuit de commande (14) pour fournir au premier conducteur (12a) un premier signal électrique et au deuxième conducteur (12b) un deuxième signal électrique ;
**caractérisé en ce qu'**il comprend en outre:
- un premier circuit à retard dépendant d'une transition de signal (16a) couplé au premier conducteur (12a) pour retarder une première transition de signal électrique ; et
- un deuxième circuit à retard dépendant d'une transition de signal (16b) couplé au deuxième conducteur (12b) pour retarder une deuxième transition de signal électrique.

2. Dispositif électronique (10) selon la revendication 1, **caractérisé en ce que** le premier circuit à retard dépendant d'une transition de signal (16a) comprend un élément logique (30 ; 40) ayant :
- une première entrée (32 ; 42) couplée à une entrée (31) du premier circuit à retard dépendant d'une transition de signal (16a) par l'intermédiaire d'un premier élément à retard d'entrée (36) ;
- une deuxième entrée (34 ; 44) couplée à l'entrée (31) du premier circuit à retard dépendant d'une transition de signal (16a) ; et
- une sortie (37 ; 47) couplée au premier conducteur (12a).

3. Dispositif électronique (10) selon la revendication 2, **caractérisé en ce que** :
- l'élément logique (30 ; 40) comprend une porte ET (30) ; et
- le premier élément à retard d'entrée (36) comprend une chaîne d'inverseurs ayant un nombre pair d'inverseurs.

4. Dispositif électronique (10) selon la revendication 2, **caractérisé en ce que** :
- l'élément logique (30 ; 40) comprend une porte NON-OU (40) ;
- le premier élément à retard d'entrée (36) comprend une chaîne d'inverseurs ayant un nombre pair d'inverseurs; la première entrée (42) et la deuxième entrée (44) de l'élément logique (40) étant couplées à l'entrée (31) du premier circuit à retard dépendant d'une transition de signal (16a) par l'intermédiaire d'un inverseur (38).

5. Dispositif électronique (10) selon la revendication 1, **caractérisé en ce que** le premier circuit à retard dépendant d'une transition de signal (16a) comprend un inverseur asymétrique (50) ayant :
- une entrée (31) couplée au circuit de commande (14) ;
- une sortie (57) couplée au premier conducteur (12a) ;
- un premier transistor (52) ayant une première résistance ; et
- un deuxième transistor (54) ayant une deuxième résistance.

6. Dispositif électronique (10) selon la revendication 5, **caractérisé en ce que** la sortie (57) de l'inverseur asymétrique (50) est couplée au premier conducteur (12a) par l'intermédiaire d'un condensateur (56) et d'un circuit tampon (58).

7. Dispositif électronique (10) selon la revendication 1, **caractérisé en ce que** le premier circuit à retard dépendant d'une transition de signal (16a) et le deuxième circuit à retard dépendant d'une transition de signal (16b) sont intégrés dans le circuit de commande (14).
